# EUROPEAN PATENT APPLICATION

(11) **EP 3 923 475 A1**
(43) Date of publication of application: **15.12.2021**
(21) Application number: 20179443.5
(22) Date of filing: 11.06.2020
(51) Int. Cl.: H03K 17/16, H03K 19/003

(54) **SLEW-RATE CONTROLLED OUTPUT DRIVER**

(71) Applicant: EM Microelectronic-Marin SA, 2074 Marin (CH)
(72) Inventor: DELLEA, M. Mario, 2300 La Chaux-de-Fonds (CH); CANCLINI, Athos, 2000 Neuchâtel (CH)
(74) Representative: ICB SA

(57) **Abstract**

The present invention concerns a slew-rate controlled driver circuit (100) for an integrated circuit having an input node (101) and an output node (102). Said slew-rate controlled driver circuit (100) comprising at least one main driver (110) configured to be connected to at least one current generator (160). Said at least one main driver (110) including at least one pair of first auxiliary driver's transistors (103), at least one first main capacitance (120) configured to reduce electromagnetic interferences, at least one first main driver transistor (130) connected to said at least one first main capacitance (120) and at least one pair of second auxiliary driver's transistors (107), at least one second main capacitance (140), and at least one second auxiliary driver transistor (150) connected to said at least one second main capacitance (140).

## Description

### Technical field

The present invention relates to the field of slew-rate controlled driver circuit and in particular relates to USB drivers.

### State of the art

In many general purpose input/output interfaces, such as USB, it is required to provide a signal that varies between a low state, typically 0 volts, and high state, typically 3.3 volts and has a controlled rise/fall time to reduce electromagnetic interference, EMI for short, and supply/ground noise.

Moreover, the transition time ratio (rise-time over fall-time) and the differential output crossover voltage range need to be well controlled. The output crossover voltage of two drivers working in opposite phases may be controlled by the ratio of the delay time to rise over the delay time to fall by using capacitive feedback.

However, if the initial conditions of said capacitive feedback on each clock cycle are not well controlled that lead to problem.

### Summary of the invention

In order to achieve this objective, the present invention provides a slew-rate controlled driver circuit for an integrated circuit and preferably of an integrated circuit; said slew-rate controlled driver circuit having an input node and an output node; said slew-rate controlled driver circuit comprising at least one main driver configured to be connected to at least one current generator; said at least one main driver including:
- at least one pair of first auxiliary driver's transistors configured to be connected to said at least one current generator;
- at least one first main capacitance; said at least one first main capacitance is configured to control rising output slope;
- at least one first main driver transistor having a first main source connected to a first terminal of a power supply, having a first main gate connected to said at least one pair of first auxiliary driver's transistors, and having a first main drain connected to said output node; said at least one first main capacitance being connected between said first main gate and said first main drain;
- at least one pair of second auxiliary driver's transistors working in opposition phase and configured to be connected to said at least one current generator;
- at least one second main capacitance; said at least one second main capacitance is configured to control falling output slope; and,
- at least one second main driver transistor having a first second source connectable to a second terminal of said power supply, having a second main gate connected to said at least one pair of second auxiliary driver's transistors, and having a second main drain connected to said output node; said at least one second main capacitance being connected between said second main gate and said second main drain.

Thus, this configuration allows providing a signal that vary between the voltage of said first terminal of said power supply, e.g. 3.3V, and the voltage of said second terminal of said power supply, e.g. 0V, at a controlled transition output slope in order to reduce electromagnetic interferences and supply noise e.g.. Moreover, the transition time ratio, i.e. rise-time over fall-time, and the differential output crossover voltage range between two slew-rate controlled driver circuit working in opposition, is well controlled.

According to an embodiment, said at least one pair of first auxiliary driver's transistors comprises a first PMOS transistor configured to connect said first main gate to the first terminal and to block the conduction of said at least one first main driver transistor and an first NMOS transistor configured to connect said first main gate to current generator and to allow the controlled conduction of said at least one first main driver transistor and/or said at least one pair of second auxiliary driver's transistors comprises a second NMOS transistor configured to connect said second main gate to the second terminal and to block the conduction of said at least one second main driver transistor and an second PMOS transistor configured to connect said second main gate to current generator and to allow the controlled conduction of said at least one second main driver transistor.

Thus, thanks this configuration, said slew-rate controlled driver circuit can control the transition times.

According to an embodiment, said at least one pair of first auxiliary driver's transistors and/or said at least one pair of second auxiliary driver's transistors is or are configured to be connected to said input node.

Thus, this configuration allows connecting of said first main gate to said first terminal of said power supply, e.g. 3.3V, or said current generator and/or of said second main gate to said second terminal of said power supply, e.g. 0V, or said current generator.

According to an embodiment, said at least one first main driver transistor is a PMOS transistor and/or said at least one second main driver transistor is an NMOS transistor.

Thanks this configuration, said at least one first main driver transistor and said at least one second main driver transistor can alternate in order to provide a output signal that vary between the voltage of said first terminal and the voltage of said second terminal of said power supply.

According to an embodiment, said at least one current generator including at least one first current source connected to at least one second current source:
- said at least one first current source configured to be connected to said second terminal of said power supply and to said at least one pair of first auxiliary driver's transistors; and,
- said at least one second current source configured to be connected to said first terminal of said power supply and to said at least one pair of second auxiliary driver's transistors.

According to an embodiment, said at least one first current source comprises a first current mirror, preferably including NMOS transistors, and/or said at least one second current source comprises a second current mirror, preferably including PMOS transistors.

Thus, this configuration allows providing a current to said at least one pair of first and second auxiliary driver's transistors when the signal varies between the voltage of said first terminal of said power supply, e.g. 3.3V, and the voltage of said second terminal of said power supply, e.g. 0V.

According to an embodiment, said first current mirror comprises a first cascoded output made of a first NMOS cascode output connected to said at least one pair of first auxiliary driver's transistors and a second NMOS cascoded output connected to said second terminal of said power supply, and an input diode connected NMOS transistor having a first NMOS source connected to said second terminal of said power supply, a first NMOS drain connected to a first NMOS gate, to a gate of said second NMOS cascoded output and preferably to a terminal of first resistor; preferably another terminal of said first resistor is connected to a gate of said first NMOS cascode output and to a terminal of a common resistor; and said second current mirror comprises a second cascoded output made of a first PMOS cascode output to said at least one pair of first auxiliary driver's transistors and a second PMOS cascoded output connected to said first terminal of said power supply, a input diode connected PMOS transistor having a first PMOS source connected to said first terminal of said power supply, a first PMOS drain connected to a first PMOS gate, to a gate of said second PMOS cascoded output and preferably to a terminal of second resistor; preferably another terminal of said second resistor is connected to a gate of said first PMOS cascode output and to another terminal of a common resistor.

Thus, this configuration allows providing a first current used to control the rising slope and a second current used to control the falling slope, having a low mismatch, which is needed to control the rising to falling slope ratio, and having a little dependence on the power supply reducing the dependence of the transition time to said power supply. Further, this configuration optimizes the relationship between the two current sources and the currents generated by this configuration depend on the supply voltage and thus reduce the dependence on the transition times of the supply voltage.

In order to achieve this objective, the present invention provides a slew-rate controlled method for an integrated circuit and preferably for a slew-rate controlled driver circuit according to the present invention; said Slew-rate controlled method including a or an:
- Transition of said input node between said second terminal of said power supply and said first terminal of said power supply;
- Connecting said output node to said first terminal of said power supply via said at least one first main driver transistor or said second terminal of said power supply via said at least one second main driver transistor;
- Conduction initiation of said at least one first main driver transistor or said at least one second main driver transistor;
- Having a constant control voltage said main driver transistors provide a constant current to a load capacitance such as to produce a linear output voltage variation and so a constant current flow through at least one first main capacitance or at least one second main capacitance;
- Having output node reaching said second terminal of said power supply or said first terminal of said power supply, and current flowing through at least one first main capacitance or at least one second main capacitance is decreasing until the currents are cancelled and allow resuming said first main gate or said second main gate transition;
- Connecting said first main gate to said first terminal of said power supply such as to switch off said at least one first main driver transistor or said second main gate said second terminal of said power supply such as to switch off said at least one second main driver transistor.

Thus, this configuration allows providing a signal that vary between the voltage of said first terminal of said power supply, e.g. 3.3V, and the voltage of said second terminal of said power supply, e.g. 0V, at a controlled transition output slope in order to reduce electromagnetic interferences and supply noise e.g.. Moreover, the transition time ratio, i.e. rise-time over fall-time, and the differential output crossover voltage range between two slew-rate controlled driver circuits working in opposition, is well controlled.

### Brief description of the drawings

The foregoing and other purposes, features, aspects and advantages of the invention will become apparent from the following detailed description of the embodiments, given by way of illustration and not limitation with reference to the accompanying drawings, in which:
- figure 1 represents a slew-rate controlled driver circuit 100 according to an embodiment; and,
- figure 2 illustrates a control sequence of slew-rate controlled method **500** according to an embodiment.

### Description of the invention

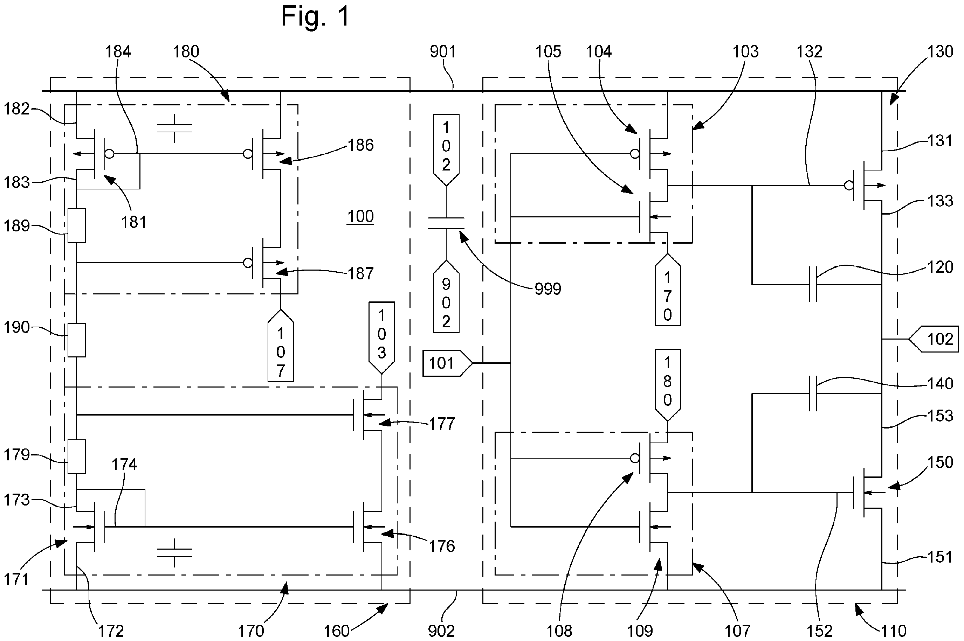

As previously mentioned, in many general purpose input/output interfaces, such as USB, it is required to provide a signal that varies between a low state, typically 0 volts, and high state, typically 3.3 volts and it is required to have a controlled rise/fall time to reduce EMI and supply/ground noise. The ratio of the rising slope over the falling slope is mainly controlled by two matched capacitive feedbacks. Furthermore, this matched capacitive feedback will help to control the output crossover voltage of two drivers working in opposite phases, which is the ratio of the delay time to rise over the delay time to fall. This transition time ratio is controlled thanks the present invention, which provides a slew-rate controlled driver circuit **100** for an integrated circuit. As illustrated in fig.1, said slew-rate controlled driver circuit **100** has an input node **101** and an output node **102,** and comprises at least one main driver **110** configured to be connected to at least one current generator **160.** Said at least one main driver **110** includes at least one pair of first auxiliary driver's transistors **103** configured to be connected to a first terminal **901** of a power supply **900,** said at least one current generator **160** and to said input node **101,** at least one first main capacitance **120,** and includes also at least one pair of second auxiliary driver's transistors **107** configured to be connected to said at least one current generator **160** and to said input node **101,** at least one second main capacitance **140.**

The state of the art uses only one feedback capacitor, which is switched each half-period of clock signal from the gate of the NMOS driver to the gate of the PMOS driver and vice versa. This topology affects seriously the ratio of the delay time to rise over the delay time to fall. Due to the capacitive feedback, the gate voltage of the drivers is constant during the transition and not too far to the threshold voltage. Then the gate voltage need to increase until de supply voltage so the feedback capacitor is fully charged before to be switched to the other gate. So the initial condition are the same for each transition. As the transition time could be a large part of the clock half-period, until circa 50%, the voltage gate slope is roughly equal to the output slope and the voltage from the "plateau" to the supply is quite large, the gate voltage as no enough time to reach the supply voltage before the end of the clock half-period. In this case, the initial condition can be very different between rise and fall transition, affecting the transition but much more the delay before transition. Therefore the present invention make use of two capacitance, said at least one first main capacitance **120** and said at least one second main capacitance **140,** and so improves the transition time ratio, i.e. rise-time over fall-time, and the differential output crossover voltage range. The output crossover voltage of two drivers working in opposite phases is mainly controlled by the ratio of the delay time to rise over the delay time to fall.

Said at least one current generator **160** includes at least one first current source **170** connected to at least one second current source **180.** Said at least one first current source **170** may be connected to a second terminal **902** of said power supply **900** and to said at least one pair of first auxiliary driver's transistors **103,** and said at least one second current source **180** may be connected to said first terminal **901** of said power supply **900** and to said at least one pair of second auxiliary driver's transistors **107,** as shown in fig. 1. It should be note that a specific implementation of the current source reduce the transition time dependency to the supply voltage and improve the transition time ratio control.

On one side, said first current mirror **170** comprises a first cascoded output **176, 177** made of a first NMOS cascode output **177** connected to said at least one pair of first auxiliary driver's transistors **103** and a second NMOS cascoded output **176** cascoded by said first NMOS cascode output **177** and connected to said second terminal **902** of said power supply **900.**

As shown in fig. 1, an input diode connected NMOS transistor **171** has a first NMOS source **172** connected to said second terminal **902** of said power supply **900,** a first NMOS drain **173** connected to a first NMOS gate **174,** to a gate of said second NMOS cascoded output **176** and, according to some embodiment, to a terminal of first resistor **179.**

Another terminal of said first resistor **179** may be connected to a gate of said first NMOS cascode output **177** and to a terminal of a common resistor **190.**

Moreover, said second current mirror **180** comprises a second cascoded output **186, 187** made of a first PMOS cascode output **187** to said at least one pair of first auxiliary driver's transistors **107** and a second PMOS cascoded output **186** cascoded by said first PMOS cascode output **187** and connected to said first terminal **901** of said power supply **900.**

An input diode connected PMOS transistor **181** has a first PMOS source **182** connected to said first terminal **901** of said power supply **900,** a first PMOS drain **183** connected to a first PMOS gate **184,** to a gate of said second PMOS cascoded output **186** and preferably to a terminal of second resistor **189.** The other terminal of said second resistor **189** is connected to a gate of said first PMOS cascode output **187** and to another terminal of a common resistor **190.**

Further, said at least one first main capacitance **120** is configured to control rising output slope and at least one first main driver transistor **130,** typically a PMOS transistor **130,** having a first main source **131** connected to said first terminal **901** of said power supply **900,** having a first main gate **132** connected to said at least one pair of first auxiliary driver's transistors **103,** and having a first main drain **133** connected to said output node **102;** said at least one first main capacitance **120** being connected between said first main gate 132 and said first main drain **133,** on one side of a load capacitance **999.**

Indeed, said output node **102,** said at least one first main capacitance **120** and said at least one second main capacitance **130** build a Y-circuit. The Y-circuit has three terminals, and on each of them, there is at least one electrical component. For example, on a terminal there is said output node **102,** on another terminal, said at least one first main capacitance **120** and on the last one, there is said at least one second main capacitance **140.**

Said at least one main driver **110** includes at least one pair of second auxiliary driver's transistors **107** working in opposition phase and configured to be connected to said second terminal **902,** to said at least one current generator **160,** to said input node **101,** and to at least one second main capacitance **140.** Said at least one second main capacitance **140** is configured to control falling output slope and at least one second main driver transistor **150** having a first second source **151** connectable to said second terminal **902** of said power supply **900,** having a second main gate **152** connected to said at least one pair of second auxiliary driver's transistors **107,** and having a second main drain **153** connected to said output node **102;** said at least one second main capacitance **140** being connected between said second main gate **152** and said second main drain **153.**

Thus, said slew-rate controlled driver circuit **100** allows providing a signal that vary between the voltage of said first terminal **901** of said power supply **900,** e.g. 3.3V, and the voltage of said second terminal **902** of said power supply **900,** e.g. 0V, at a controlled transition output slope in order to reduce electromagnetic interferences and supply noise e.g.. Moreover, the transition time ratio, i.e. rise-time over fall-time, and the differential output crossover voltage range between two slew-rate controlled driver circuit working in opposition, is well controlled.

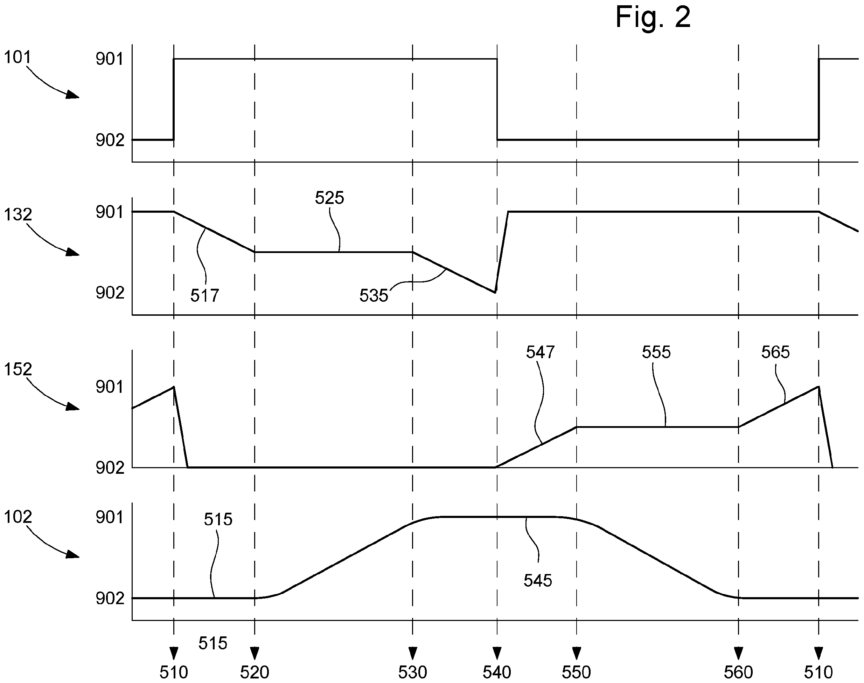

In fact, said slew-rate controlled driver circuit **100** implements a slew-rate controlled method **500** as shown in fig. 2.

Said input node **101,** typically a clock signal input, may transition **510** from low state to high state, e.g. from said second terminal voltage value **902** to said first terminal voltage value **901.**

At the same time, said output node **102** may be connected **515** to said first terminal **901** of said power supply **900** via said at least one first main driver transistor **130,** which is switched ON and starts to conduct **517** when a second NMOS transistor **109,** which is comprised by said at least one pair of second auxiliary driver's transistors **107,** connects said second main gate **152** to the second terminal **902** and so switches OFF said at least one second main driver transistor **150,** typically an NMOS transistor **150.**

More precisely, a first NMOS transistor **105** connects said first main gate **132** to current generator **160** and allows the controlled conduction of said at least one first main driver transistor **130.**

Indeed, by having a constant control voltage **525,** said first main driver transistors **130** provides a constant current to a load capacitance **999** such as to produce a linear output voltage variation and so a constant current flows through at least one first main capacitance **120.**

As soon as, the voltage of said first terminal **901** of said power supply **900** is reached **530,** current flowing through at least one first main capacitance **120** starts to decrease until the currents are cancelled and this allows resuming said first main gate **132** transition and said at least one first main driver transistor **130** is switched OFF, since said input node **101** may transition **540** from high state to low state, e.g. said first terminal voltage value **901** to said second terminal voltage value **902** such as to connect said first main gate **132** to said first terminal **901** of said power supply **900.**

At that moment, said slew-rate controlled method **500** starts the second half-period of clock signal and said load capacitance **999** may be connected **545** between said output node **102** and said second terminal **902** of said power supply **900** via said at least one second main driver transistor **150.** As a result, said at least one second main driver transistor **150** is switched ON and starts to conduct **547,** when a first PMOS transistor **104,** which is comprised by said at least one pair of first auxiliary driver's transistors **103,** connects said first main gate **132** to the first terminal **901** and so switches OFF said at least one first main driver transistor **130.**

More specifically, a second PMOS transistor **108** connects said second main gate **152** to current generator **160** and so allows the controlled conduction of said at least one second main driver transistor **150.**

Indeed, by having a constant control voltage **555,** said second main driver transistors **150** provides a constant current to a load capacitance **999** such as to produce a linear output voltage variation and so a constant current flows through at least one second main capacitance **140.**

As soon as, the voltage of said second terminal **902** of said power supply **900** is reached **560,** current flowing through at least one second main capacitance **140** starts to increase until the currents are cancelled and this allows resuming said second main gate **152** transition and said at least one second main driver transistor **150** is switched OFF, since said input node **101** may transition **510** from low state to high state such as to connect said second main gate **152** to said second terminal **902** of said power supply **900.**

Thus, the signal that vary between the voltage of said first terminal **901** of said power supply **900,** e.g. 3.3V, and the voltage of said second terminal **902** of said power supply **900,** e.g. 0V, at a controlled transition output slope in order to reduce electromagnetic interferences and supply noise e.g.. Moreover, the transition time ratio, i.e. rise-time over fall-time, and the differential output crossover voltage range between two slew-rate controlled driver circuit working in opposition, is well controlled.

In other words, when said clock signal input **101,** may transition **540** from high state to low state, the initial conditions may be:
- said output node **102** may be equal to said first terminal voltage value **901;**
- said first main gate 132 may be around 10% to 20% of said first terminal voltage value 901; and,
- said second main gate 152 may be equal to said second terminal voltage value 902.

Said first PMOS transistor **104** connects said first main gate **132** to the first terminal **901** and so switches OFF said at least one first main driver transistor **130.**

Said second PMOS transistor **108** is turned on and allows a pull-up current to charge said second main gate **152** and so allows the controlled conduction of said at least one second main driver transistor **150.**

When said second main gate **152** exceeds the threshold voltage of said at least one second main driver transistor **150,** said output node **102** starts to fall pulling a current, proportional to its falling slope, from said at least one second main capacitance **140.** When this current reach the value of the pull-up current of said at least one second current source **180,** said second main gate **152** stops to vary **555.** Then said output node **102** continues to fall at the constant slope, regardless of its load capacitance **999.** When said output node **102** reaches said second terminal voltage value **902,** said second main gate **152** resumes its rise until said input node **101** is passing from low state to high state.

Thus said second NMOS transistor **109** connects said second main gate **152** to said second terminal **902** making said at least one second main driver transistor **150** off, as a first NMOS transistor **105** allowed the pull-down of said first main gate **132** starting, said output node **102** rise transition in the same way that the said output node **102** fall transition seen above.

Thus, the minimum slope, or the maximum transient time is when the voltage of said first main gate **132** is flat **525** or when the voltage of said second main gate **152** is flat **555,** which may be equal half of the clock period. When said last transition time **535** of said first main gate **132** starts, i.e. after the voltage of said first terminal **901** of said power supply **900** is reached **530,** the rising transition of said output node **102** is done **545,** i.e. when said first terminal of said power supply is connected via said at least one first main driver transistor. Thus, said input node **101** can fall and start the next half-period **540.** That's mean said last transition time **535,** last transitions time of said first main gate **132,** can be short close to zero time duration, allowing the maximum transition time to be quite close to the half of the clock period

The same occurs for said second main gate **152** and last transition time 565. Indeed, as illustrated in fig. 2, said last transition time **565** of said second main gate **152** starts, i.e. after the voltage of said second terminal **902** of said power supply **900** is reached **560,** the falling transition of said output node **102** is done **515,** i.e. when said second terminal of said power supply is connected via said at least one second main driver transistor. Thus, said input node **101** can rise **510** and start the next half-period. That's mean said last transition time **565,** last transitions time of said second main gate **152,** can be short close to zero time duration, allowing the maximum transition time to be quite close to the half of the clock period.

In case, where there is only one capacitor which one of its electrodes is connected to the output node **102** and the other one is switched between said first main gate **132** and said second main gate **152** at transition **510, 540** of said input node **101,** the last transition time **535** of said first main gate **132** may be long enough so that the voltage at said first main gate **132** can reach to said second terminal voltage value **902** and the last transition time **565** of said second main gate **152** may be long enough so that the voltage at said second main gate **152** can reach to said first terminal voltage value **901.**

So said load capacitance **999** is always in the same initial condition which is full charged at power supply voltage. This constraint limits the maximum transition time to less than a quarter of the clock period.

In this particular case, the maximum transient time as to be smaller than a quarter of the clock period. Just after switching, the gate voltage of the main driver that will control the next transition depends of the charge in the capacitor and the ratio between this capacitor and the main driver gate capacitance. As the gate capacitor of the two main drivers are not the same, the initial conditions for both transitions are not the same. That will affected at least the crossover voltage. One solution may be to reduce this effect by having a capacitor much bigger than the main driver gate capacitors. However, the main drawback is the space needed in the integrated circuit, in terms of area, compared to the present invention.

If in addition the initial gate voltage is higher than the threshold during slope regulation, the main transistor will be to much conductive at the beginning of the transition producing a higher slope than the controlled slope, until the loop reaches its target value. That will affect both the ratio between rise and fall time and cross-overvoltage.

Finally, the target transition time as to be much smaller than the half of the clock period, the value of the capacitor as to be much bigger than the main driver gate capacitors, a non-overlapping clock is needed, and the conduction of the switches must not affect the performances, which is not the case in the present invention.

## Claims

1. Slew-rate controlled driver circuit (100) for an integrated circuit and preferably of an integrated circuit; said slew-rate controlled driver circuit (100) having an input node (101) and an output node (102); said slew-rate controlled driver circuit (100) comprising at least one main driver (110) configured to be connected to at least one current generator (160); said at least one main driver (110) including:
- at least one pair of first auxiliary driver's transistors (103) configured to be connected to said at least one current generator (160);
- at least one first main capacitance (120); said at least one first main capacitance (120) is configured to control rising output slope;
- at least one first main driver transistor (130) having a first main source (131) connected to a first terminal (901) of a power supply (900), having a first main gate (132) connected to said at least one pair of first auxiliary driver's transistors (103), and having a first main drain (133) connected to said output node (102); said at least one first main capacitance (120) being connected between said first main gate (132) and said first main drain (133);
- at least one pair of second auxiliary driver's transistors (107) working in opposition phase and configured to be connected to said at least one current generator (160);
- at least one second main capacitance (140); said at least one second main capacitance (140) is configured to control falling output slope; and,
- at least one second main driver transistor (150) having a first second source (151) connectable to a second terminal (902) of said power supply (900), having a second main gate (152) connected to said at least one pair of second auxiliary driver's transistors (107), and having a second main drain (153) connected to said output node (102); said at least one second main capacitance (140) being connected between said second main gate (152) and said second main drain (153).

2. Slew-rate controlled driver circuit (100) according to claim 1, wherein said at least one pair of first auxiliary driver's transistors (103) comprises a first PMOS transistor (104) configured to connect said first main gate (132) to the first terminal 901 and to block the conduction of said at least one first main driver transistor (130) and an first NMOS transistor (105) configured to connect said first main gate (132) to current generator 160 and to allow the controlled conduction of said at least one first main driver transistor (130) and/or said at least one pair of second auxiliary driver's transistors (107) comprises a second NMOS transistor (109) configured to connect said second main gate (152) to the second terminal 902 and to block the conduction of said at least one second main driver transistor (150) and an second PMOS transistor (108) configured to connect said second main gate (152) to current generator 160 and to allow the controlled conduction of said at least one second main driver transistor (150).

3. Slew-rate controlled driver circuit (100) according to claim 1 or 2, wherein said at least one pair of first auxiliary driver's transistors (103) and/or said at least one pair of second auxiliary driver's transistors (107) is or are configured to be connected to said input node (101).

4. Slew-rate controlled driver circuit (100) according to any preceding claims, wherein said at least one first main driver transistor (130) is a PMOS (130) transistor and/or said at least one second main driver transistor (150) is an NMOS transistor (150).

5. Slew-rate controlled driver circuit (100) according to any preceding claims, wherein said at least one current generator (160) including at least one first current source (170) connected to at least one second current source (180):
- said at least one first current source (170) configured to be connected to said second terminal (902) of said power supply (900) and to said at least one pair of first auxiliary driver's transistors (103); and,
- said at least one second current source (180) configured to be connected to said first terminal (901) of said power supply (900) and to said at least one pair of second auxiliary driver's transistors (107).

6. Slew-rate controlled driver circuit (100) according to claim 5, wherein said at least one first current source (170) comprises a first current mirror (170), preferably including NMOS transistors, and/or said at least one second current source (180) comprises a second current mirror (180), preferably including PMOS transistors.

7. Slew-rate controlled driver circuit (100) according to claim 6, wherein:
- said first current mirror (170) comprises a first cascoded output (176, 177) made of a first NMOS cascode output (177) connected to said at least one pair of first auxiliary driver's transistors (103) and a second NMOS cascoded output (176) connected to said second terminal (902) of said power supply (900), and an input diode connected NMOS transistor (171) having a first NMOS source (172) connected to said second terminal (902) of said power supply (900), a first NMOS drain (173) connected to a first NMOS gate (174), to a gate of said second NMOS cascoded output (176) and preferably to a terminal of first resistor (179); preferably another terminal of said first resistor (179) is connected to a gate of said first NMOS cascode output (177) and to a terminal of a common resistor (190); and,
- said second current mirror (180) comprises a second cascoded output (186, 187) made of a first PMOS cascode output (187) to said at least one pair of first auxiliary driver's transistors (107) and a second PMOS cascoded output (186) connected to said first terminal (901) of said power supply (900), a input diode connected PMOS transistor (181) having a first PMOS source (182) connected to said first terminal (901) of said power supply (900), a first PMOS drain (183) connected to a first PMOS gate (184), to a gate of said second PMOS cascoded output (186) and preferably to a terminal of second resistor (189); preferably another terminal of said second resistor (189) is connected to a gate of said first PMOS cascode output (187) and to another terminal of a common resistor (190).

8. Slew-rate controlled method (500) for an integrated circuit and preferably for a slew-rate controlled driver circuit (100) according to any preceding claims 1 to 7; said Slew-rate controlled method (500) including a or an:
- Transition (510, 540) of said input node (101) between said second terminal (902) of said power supply (900) and said first terminal (901) of said power supply (900);
- Connecting (515, 545) said output node (102) to said first terminal (901) of said power supply (900) via said at least one first main driver transistor (130) or said second terminal (902) of said power supply (900) via said at least one second main driver transistor (150);
- Conduction initiation (517, 547) of said at least one first main driver transistor (130) or said at least one second main driver transistor (150);
- Having a constant control voltage (525, 555) said main driver transistors (130, 150) provide a constant current to a load capacitance (999) such as to produce a linear output voltage variation and so a constant current flow through at least one first main capacitance (120) or at least one second main capacitance (140);
- Having output node (102) reaching said second terminal (902) of said power supply (900) or said first terminal (901) of said power supply (900), and current flowing through at least one first main capacitance (120) or at least one second main capacitance (140) is decreasing until the currents are cancelled and allow resuming said first main gate (132) or said second main gate (152) transition;
- Connecting said first main gate (132) to said first terminal (901) of said power supply (900) such as to switch off said at least one first main driver transistor (130) or said second main gate (152) said second terminal (902) of said power supply (900) such as to switch off said at least one second main driver transistor (150).
